# EUROPÄISCHE PATENTSCHRIFT

(11) **EP 0 742 957 B1**
(45) Veröffentlichungstag und Bekanntmachung des Hinweises auf die Patenterteilung: **31.03.1999**
(21) Anmeldenummer: 95906355.3
(22) Anmeldetag: 28.01.1995
(51) Int. Cl.: H01L 29/745, H01L 29/749

(54) **MOS-GESTEUERTER THYRISTOR**
MOS-CONTROLLED THYRISTOR
THYRISTOR A COMMANDE MOS

(30) Priorität: 01.02.1994 DE 4402877
(43) Veröffentlichungstag der Anmeldung: 20.11.1996
(73) Patentinhaber: Daimler-Benz Aktiengesellschaft, 70546 Stuttgart (DE)
(72) Erfinder: SCHLANGENOTTO, Heinrich, D-63263 Neu-Isenburg (DE)
(74) Vertreter: Fröhling, Werner Otto, Dr.
(86) Internationale Anmeldenummer: EP9500301
(87) Internationale Veröffentlichungsnummer: WO9521460

(56) Entgegenhaltungen:
- EP-A- 0 433 825
- DE-A- 3 408 516
- DE-A- 4 310 606

## Beschreibung

Die Erfindung bezieht sich auf ein durch MOS-Gate schaltbares Leistungshalbleiterbauelement mit einem Halbleiterkörper, der eine Vielzahl nebeneinander angeordneter, parallel geschalteter, eine Thyristorstruktur bildende Einheitszellen aufweist, die aus einer an die Anode angrenzenden p-Emitterzone, einer sich daran anschließenden schwach dotierten n-Basiszone, einer darauf folgenden p-Basiszone und einer sich daran anschließenden n-Emitterzone bestehen, in die paarweise p+-Zonen eingebettet sind, die zusammen mit dem zwischen ihnen liegenden n-Gebiet und einem darüber angeordneten isolierten Gate einen lateralen ersten p-Kanal-MOSFET bilden, wobei einerseits das am Rande der Emitterzone liegende Draingebiet mit der äußeren Kathode verbunden ist, die keinen Kontakt mit der n-Emitterzone hat, und andererseits das innen liegende Sourcegebiet mit einem floatenden Kontakt versehen ist, der gleichzeitig die n-Emitterzone kontaktiert, und wobei aus der mit der äußeren Kathode kontaktierten p+-Zone, dem Oberflächenbereich der p-Basiszone und dem dazwischen liegenden Bereich der n-Emitterzone zusammen mit einem isolierten Gate ein zweiter p-Kanal-MOSFET gebildet wird.

Ein derartiges Leistungshalbleiterbauelement ist aus der DE 41 26 491 bekannt. Bei diesem Leistungshalbleiterbauelement ist in die n-Emitterzone des Thyristors ein p-Kanal-MOSFET integriert, der aus zwei eingebetteten p+-Zonen als Source- und Draingebiet sowie dem über dem n-leitenden Zwischengebiet angeordneten MOS-Gate gebildet wird. Die am Rande der n-Emitterzone gelegene Drain-p+-Zone ist mit der Kathode als Kontaktelektrode verbunden, die Source-p+-Zone und der benachbarte Teil der n-Emitterzone sind mit einem floatenden Metallkontakt versehen, der den MOSFET und den Thyristor ohmsch miteinander verbindet, so daß sie in Serie liegen. Ein zweiter p-Kanal-MOSFET M2 wird durch die an die Oberfläche geführte p-Basis des Thyristors, dem mit der Kathode kontaktierten p+-Gebiet am Rande der n-Emitterzone sowie dem dazwischen liegenden Teil der n-Emitterzone mit dem darüber angeordneten isolierten Gate G2 gebildet.

Zum Abschalten des Bauelements wird der in Serie mit dem Thyristor liegende MOSFET M1 abgeschaltet und gleichzeitig der MOSFET M2 eingeschaltet, wodurch ein Nebenweg von der p-Basis des Thyristors zur Kathode erzeugt wird. Dazu müssen die Gates der beiden MOSFETs mit verschiedenen Gatesignalen angesteuert werden. Um ein gutes Abschaltverhalten und einen großen sicheren Arbeitsbereich (SOA) beim Abschalten zu erreichen, müssen die beiden Gatesignale zeitlich und in ihrer absoluten Größe sehr genau aufeinander abgestimmt sein. Durch Störungen in der Korrelation der Gatesignale wird der sichere Arbeitsbereich reduziert, und es kommt leicht zur Zerstörung des Bauelements. Da auch eine erheblich aufwendigere Treiberelektronik erforderlich ist, bedeutet die Abschaltung über zwei Gates mit verschiedenen aber aufeinander abzustimmenden Steuersignalen einen großen praktischen Nachteil gegenüber anderen Bauelementen wie zum Beispiel dem IGBT. Ein Nachteil besteht auch darin, daß das Bauelement keine Kennlinie mit Stromsättigung hat, d. h. der Strom strebt mit zunehmender Spannung nicht gegen einen Sättigungswert. Der Strom wird also im Falle eines Kurzschlusses der Last nicht durch das Bauelement selbst begrenzt, so daß, um einer Zerstörung im Kurzschlußfall vorzubeugen, Sicherungen vorgeschaltet werden müssen. Dies gilt auch dann, wenn man einen der Gateanschlüsse und den Kathodenanschluß außen miteinander verbindet. Infolge des inneren Widerstandes des Gate-Kathodenkreises, bedingt u. a. durch das Polysiliziumgate, bleibt das Gate bei einem schnellen Strom- und Spannungsanstieg nicht auf Kathodenpotential. Das Bauelement ist mit anderen Worten nicht kurzschlußfest.

Zum Einschalten des aus DE 41 26 491 A1 bekannten Bauelements ist ein dritter von außen angesteuerter MOSFET integriert, um den Thyristor zu zünden. Dieser MOSFET der als n-Kanal-MOSFET vom Anreicherungstyp (selbstsperrend oder "normally-off") ausgebildet ist, verbindet im eingeschalteten Zustand die n-Emitterzone mit der n-Basis des Thyristors. Zum Einschalten des Bauelements werden der erste und der dritte MOSFET eingeschaltet und der zweite MOSFET abgeschaltet. Das für das Einschalten hinzukommende Gate erhöht den erforderlichen Aufwand für die Treiberelektronik weiter.

Aus der Deutschen Offenlegungsschrift DE 43 10 606 A1 ist GTO Thyristor bekannt, der eine p-leitende Emitterschicht, eine n-leitende Basisschicht, eine p-leitende Basisschicht und eine n-leitende Emitterschicht enthält. Auf der p-leitenden Basisschicht ist in unmittelbarer Nähe zur n-leitenden Emitterschicht eine zusätzliche n-leitende Schicht gebildet. Auf dieser ist eine zusätzliche p--leitende Schicht ausgebildete die sich zur n-leitenden Emitterschicht erstreckt. Die n-leitende Emitterschicht und die zusätzliche p--leitende Schicht stehen über eine im Potential nicht festgelegte Elektrode in Verbindung. Um parasitäre Transistoren bzw. Thyristoren zu vermeiden, die ein unsicheres Schalten der Anordnung herbeiführen würden. sind ein erster FET (TR1a) und eine zweiter FET (TR2a) intergriert. Damit wird ein sicheres Abschalten des Thyristors ermöglicht.

Aus der Europäischen Patentanmeldung EP 0433825A1 ist ein abschaltbares Leistungshalbleiter-Bauelement bekannt geworden, bei dem ein nichtlinearer Emitter-Ballastwiderstands in das Halbleitersubstrat zwischen dem Emittergebiet und die dazugehörige Metallisierung eingebaut ist, um eine erhöhte Festigkeit gegen Stromfilamentierung beim Abschalten zu erreichen. Maßnahmen, um ein Abschalten von höheren Spannungen und bei schnellem Spanungsanstieg zu ermöglichen, sind nicht vorgesehen.

Feldeffekt-gesteuerte Halbleiterleistungsbauelemente, im folgenden auch Bauelemente genannt, werden in Form des Leistungs-MOSFETs und des Insulated-Gate-Bipolartransistors (IGBT) bereits in großem Umfang praktisch eingesetzt. Die Durchlaßspannung von MOSFETs nimmt mit steigender Sperrspannung, für die sie dimensioniert sind, wegen der fehlenden Leitfähigkeitsmodulation stark zu, so daß MOSFETs nur bis ungefähr 500 V verwendet werden. Der IGBT weist als bipolares Bauelement bei Sperrspannungen oberhalb 300 V ein besseres Durchlaßverhalten auf als ein MOSFET. Verglichen mit MOS-gesteuerten Thyristoren, wie dem Bauelement gemäß der DE 41 26 491 A1, ist das Durchlaßverhalten des IGBT aber oberhalb etwa 600 V Sperrvermögen schlechter, da seine Durchlaß- und Sperreigenschaften durch einen bipolaren Transistor - nicht durch einen Thyristor - bestimmt werden. Der schaltbare Strom pro Chip-Fläche ist daher geringer als bei dem Bauelement gemäß der DE 41 26 491. Ein Vorteil des IGBT ist aber, daß er ebenso wie der Leistungs-MOSFET durch ein Gate sowohl ein- als auch abgeschaltet werden kann und eine Kennlinie mit Stromsättigung aufweist.

Bekannt sind auch spezielle MOS-gesteuerte Thyristoren (MCTs), die einen in die n-Emitterzone integrierten MOSFET enthalten, der beim Einschalten einen Nebenweg von der p-Basis zur Kathode öffnet und das Bauelement hierdurch abschaltet. Das Abschaltverhalten dieses Bauelements ist aber durch Stromfilamentierung beeinträchtigt. Die Durchlaßkennlinie des MCT gleicht der eines üblichen Thyristors, d. h. sie weist keine Stromsättigung auf. Auch der MCT daher nicht "kurzschlußfest", was als erheblicher Nachteil etwa gegenüber dem IGBT angesehen wird. Vor allem aber wegen der Stromfilamentierung konnten sich MCTs in der Praxis nicht durchsetzen.

Ein anderer MOS-gesteuerter Thyristor, den man als "Emitter-Switched-Thyristor" oder EST bezeichnet, wurde in Artikeln von Baliga und Mitarbeitern beschrieben, siehe IEEE Trans. Electron Devices 38 (1991), S. 1619. Beim EST ist in die p-Basis des Thyristors ein MOSFET integriert, der mit der Thyristorstruktur in Serie liegt. Durch Abschalten des MOSFETs schaltet der EST ab. Ein Nachteil dieses Bauelements besteht darin, daß es einen mit der Kathode kontaktierten parasitären Thyristor enthält. Um das Einschalten dieses Thyristors zu verhindern, wird die p-Basis zusammen mit dem n-Emitter durch die Kathodenmetallisierung kontaktiert, d. h. mit der Kathode kurzgeschlossen. Dies hat jedoch zur Folge, daß auch der floatende Hauptthyristor bis zu einem erheblichen Abstand von der Kurzschlußstelle am Einrasten gehindert wird. Daher muß das Einzelelement eine relativ große laterale Abmessung haben, so daß die pro Halbleiterfläche erreichbare MOS-Kanalweite und damit der schaltbare Strom pro Fläche auch hier stark reduziert sind. Durch den vorgeschalteten MOSFET zeigt die Kennlinie andeutungsweise eine Strombegrenzung. Diese ist nur wenig ausgeprägt, weil der MOSFET bei den üblichen Betriebsbedingungen schon in den Durchbruch läuft, bevor der Übergang zwischen p- und n-Basis, der eine höhere Spannung ermöglicht, wesentlich zu sperren beginnt.

Der Erfindung liegt die Aufgabe zugrunde, ein MOS-gesteuertes Leistungshalbleiterbauelement der eingangs beschriebenen Art derart weiterzuentwickeln, daß es durch ein einziges Gate abschaltbar ist und eine Kennlinie mit Stromsättigung hat. Das Leistungshalbleiterbauelement soll auch dahingehend weiterentwickelt werden, daß es durch dieses Gate auch einschaltbar ist.

Die Aufgabe wird gemäß Anspruch 1 dadurch gelöst, daß die Durchbruchs spannung des ersten lateralen p-Kanal-MOSFETs zwischen der äußeren Kathode und dem floatenden Kontakt den Absolutbetrag der Schwellenspannung des zweiten MOSFETs um mehr als zwei Volt übersteigt und daß die Gateelektrode des zweiten MOSFETs von der Kathodenmetallisierung mitgebildet oder überdeckt wird. Dieses Leistungshalbleiterbauelement wird durch eine Gatespannung, die gegenüber der Kathode positiv oder gegenüber dem floatenden Kontakt null oder positiv ist, abgeschaltet. Es benötigt nur eine einfache Ansteuerschaltung, wie sie auch bei MOSFETs und IGBTs verwendet wird. Dies ist für den praktischen Einsatz ein bedeutender Vorteil. Darüberhinaus ist das Leistungshalbleiterbauelement für einen weiten Sperrspannungsbereich geeignet, kann einen hohen Strom pro Fläche bei kleiner Durchlaßspannung schalten und hat eine Kennlinie mit Stromsättigung.

Ein Leistungshalbleiterbauelement, bei dem in einem Teil der Einheitszellen ein Oberflächenbereich der n-Basiszone, die n-Emitterzone und der dazwischenliegende Oberflächenbereich der p-Basiszone zusammen mit einem isolierten Gate einen n-Kanal-MOSFET bilden, ist erfindungsgemäß derart ausgebildet, daß der n-Kanal MOSFET vom Verarmungstyp ist, daß der Absolutbetrag der Schwellenspannung des MOSFETs vom Verarmungstyp wenigstens um zwei Volt kleiner als die Durchbruchsspannung des ersten p-Kanal-MOSFETs ist und daß die Gateelektrode des MOSFETs vom Verarmungstyp von der Kathodenmetallisierung mitgebildet oder überdeckt wird. Dieses Leistungshalbleiterbauelements wird durch eine negative Spannung am Gate des ersten MOSFETs eingeschaltet, so daß durch ein einziges externes Gate sowohl einals auch abgeschaltet werden kann. Zum Einschalten wird eine negative Gatespannung angelegt und zum Abschalten wird das Gate auf das Potential der floatenden Kathode gelegt oder gegenüber der Kathode positiv eingestellt. Hiermit erhält man ein Bauelement, das mit einer ebenso einfachen Ansteuerschaltung, wie andere MOS-Bauelemente, z. B. der IGBT, auskommt. Verglichen mit diesen bekannten Bauelementen ist der schaltbare Strom pro Chip-Fläche wesentlich größer bei gleichzeitig kleinerer Durchlaßspannung. Außerdem ist das Bauelement für hohe Sperrspannungen geeignet. Zum Einschalten müssen demgegenüber bei dem aus der DE 41 26 491 A1 bekannten Halbleiterbauelement der erste und dritte MOSFET eingeschaltet und der zweite MOSFET gleichzeitig abgeschaltet sein. Hierfür sind für die verschiedenen MOSFETs unterschiedliche Gatesignale erforderlich, wie dies insbesondere in Spalte 7, Zeilen 21 - 25 der DE 41 26 491 beschrieben wird.

Weitere zweckmäßige Ausgestaltungen der Erfindung sind in den Ansprüchen 3 bis 6 beschrieben.

Die Erfindung wird nun anhand von in einer Zeichnung dargestellten Ausführungsbeispielen näher erläutert, aus denen sich weitere Einzelheiten, Merkmale und Vorteile ergeben.

Es zeigen
- Fig. 1: eine Einheitszelle eines Leistungshalbleiterbauelements in einer zum Abschalten ausgebildeten Form (normale Zelle),
- Fig. 2: das Leistungshalbleiterbauelement nach Fig. 1 mit Potentialwerten beim Abschalten,
- Fig. 3: ein Leistungshalbleiterbauelement mit einer normalen und einer sowohl zum Abschalten als auch zum Zünden ausgebildeten Einheitszelle.

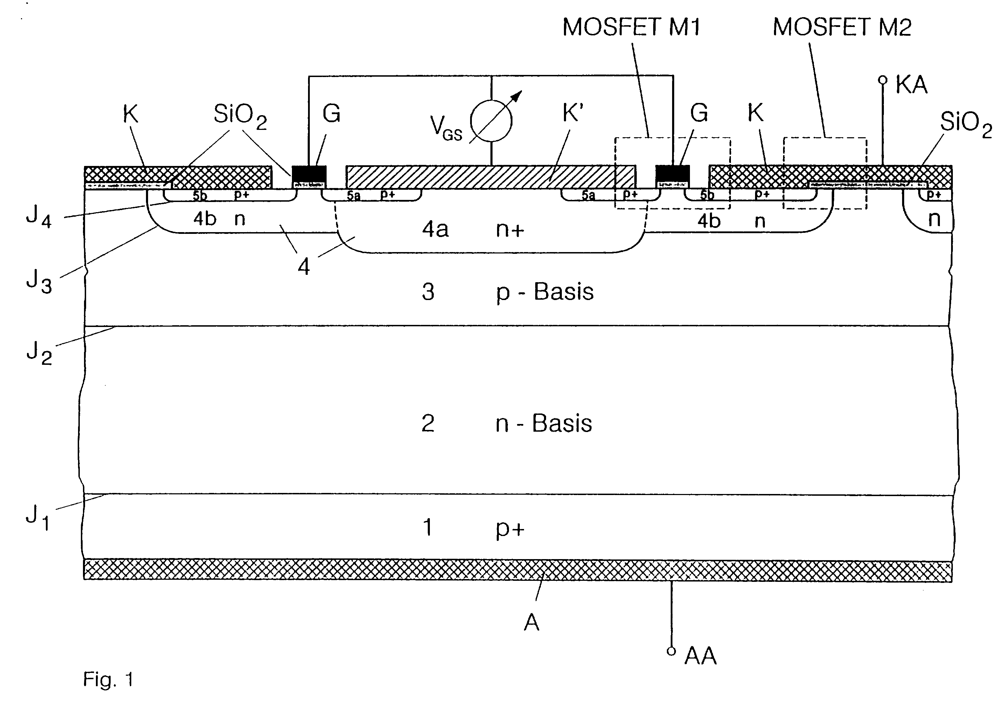

Wie Fig. 1 im Querschnitt zeigt, weist ein Halbleiterkörper eines Leistungshalbleiterbauelements eine pnpn-Thyristorstruktur auf, bestehend aus einer an die Anode A angrenzenden p-Emitterzone 1, einer sich daran anschließenden schwach dotierten n-Basiszone 2, einer darauf folgenden p-Basis-Zone 3, auch p-Basis genannt, und einer darin eingebetteten n-Emitterzone 4, die in Richtung senkrecht zur Bildebene vorzugsweise streifenförmig ausgebildet ist. Die n-Emitterzone ist bevorzugt in einen hoch dotierten zentralen Bereich 4a und in schwächer dotierte Seitenbereiche 4b unterteilt. In die Seitenbereiche der Zone 4 sind je ein Paar hoch dotierte p⁺-Zonen 5a,5b eingebettet, die parallel zum Rand der n-Emitterzone verlaufen. Jedes Paar der p⁺-Zonen bildet zusammen mit dem Zwischengebiet der n-Zone 4 und einem darüber angeordneten isolierten Gate G einen p-Kanal-MOSFET M1. Die n-Emitterzone ist im mittleren, höher dotierten Bereich 4a mit einer floatenden Kathodenmetallisierung K' versehen, die auch den nach innen liegenden p⁺-Streifen 5a jedes p⁺-Zonenpaares ohmsch kontaktiert. Die am Rand der n-Emitterzone 4 gelegenen p⁺-Streifen 5b sind mit einer Metallschicht K kontaktiert, die als äußere Kathode des Bauelements dient und keinen Kontakt mit der n-Emitterzone 4 hat. Die Kathode ist mit einem Kathodenanschluß KA versehen. Der MOSFET (M1) liegt in Serie mit der Thyristorstruktur unterhalb der floatenden Kathode K'. In Vorwärts- oder Schaltrichtung ist die Anode A positiv gegenüber der äußeren Kathode K gepolt.

Fig. 1 zeigt einen zweiten MOSFET-Bereich M2 zwischen p-Basis 3 und der mit der Kathode kontaktierten p⁺-Zone 5b. Das durch ein Dielektrikum, in Fig. 1 als SiO₂ eingezeichnet, isolierte Gate dieses MOSFETs M2 wird von der Kathodenmetallisierung mitgebildet oder überdeckt.

Zunächst wird das Abschalten aus dem Durchlaßzustand beschrieben. Ein Durchlaßstrom kann nur fließen, wenn das Potential des Gates G gegenüber der floatenden Kathode K', die die Source-Elektrode des MOSFETs (M1) darstellt, negativ ist und einen p-leitenden Inversionskanal zwischen der das Sourcegebiet bildenden Zone 5a des MOSFETs (M1) und der das Draingebiet bildenden Zone 5b erzeugt. Der von der floatenden Kathode K' zur Kathode K fließende Löcherstrom findet in der anderen Richtung seine Fortsetzung in einem gleich großen Elektronenstrom von K' in die Thyristorstruktur hinein. Zum Abschalten wird die Gatespannung, absolut genommen, auf einen Wert unterhalb der Schwellenspannung V_{T}, z. B. auf 0, abgesenkt, so daß der p-Kanal zwischen Sourcegebiet 5a und Draingebiet 5b verschschwindet. Somit fließen von K' keine Elektronen mehr in den Thyristor hinein. Da aber noch viele überschüssige Ladungsträger in der Struktur vorhanden sind und der zwischen den n- und p-Basiszonen vorhandene pn-Übergang J₂, der allein eine hohe Sperrspannung aufnehmen kann, noch nicht sperrt, würde das Bauelement so ohne weitere Vorkehrungen nur gegen eine Spannung abschalten, die kleiner ist als die Durchbruchspannung des MOSFETs M1 von z. B. 12 V. Nur bei sehr langsamen Spannungsanstieg, bei dem die Ladungsträger Zeit hätten, durch Rekombination zu verschwinden, wäre ein Abschalten gegen höhere Spannungen möglich. Bei den üblichen höheren Spannungen und Schaltgeschwindigkeiten aber würde der MOSFET in den Durchbruch getrieben, und die Thyristorstruktur 1,2,3,4a würde weiter voll mit Strom versorgt, wobei die Spannung am Bauelement um die Durchbruchspannung des MOSFETs erhöht ist.

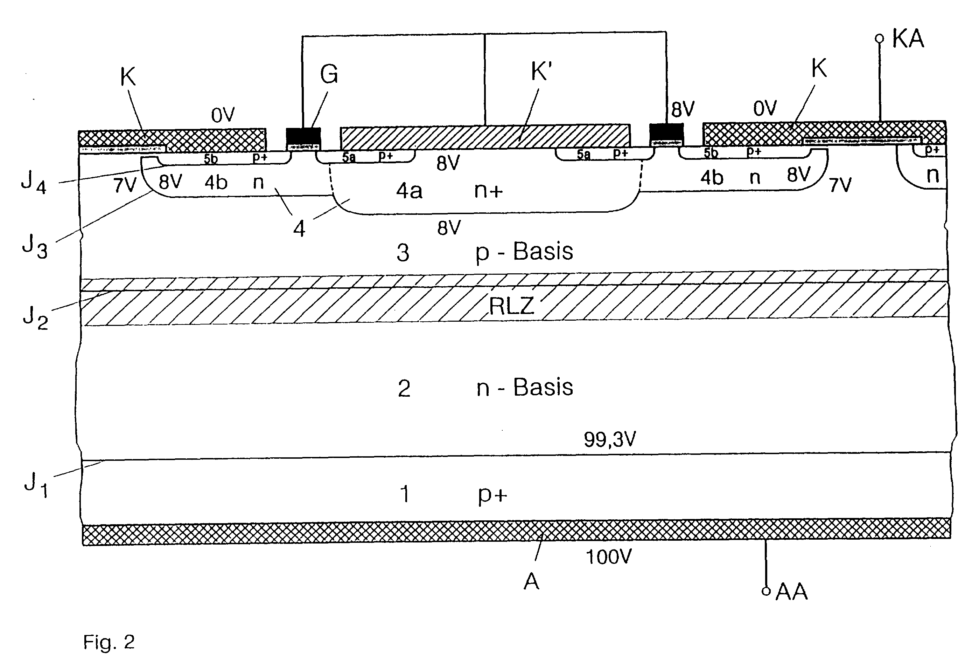

Um ein Abschalten gegen höhere Spannungen und bei schnellem Spannungsanstieg zu ermöglichen, enthält das erfindungsgemäße Bauelement den MOSFET M2, dessen Gate von der Kathodenmetallisierung mitgebildet wird. Um die Funktion des MOSFETs M2 zu verdeutlichen, ist die Struktur in Fig. 2 mit Werten für das Potential in einem Zeitpunkt beim Abschalten versehen, in welchem die Anode schon eine Spannung von 100 V gegenüber der Kathode habe. Die angegebenen Werte gelten für das äußere Potential ohne die durch die pn-Übergänge eingeprägten Spannungen, wobei das Potential der Kathode K gleich null gesetzt ist. Da das Gate G zum Abschalten auf das Potential des Source K' gelegt ist und Sourcegebiet 5a und Draingebiet 5b nicht mehr durch einen p-Kanal verbunden sind, baut sich zwischen K' und K eine Spannung auf, die in dem Beispiel 8 V beträgt. Um diese Spannung ist der pn-Übergang J₄ zwischen Draingebiet 5b und n-Emitterzone 4b in Sperrichtung gepolt. ist nun die Schwellenspannung des MOSFETs M2 kleiner, z. B. 4 V, so bildet sich über der n-Zone zwischen dem p⁺-Gebiet 5b und p-Basis ein p-Kanal, weil das Gate von M2 gegenüber dem Halbleiter negativ gepolt ist. Da aus der floatenden Kathode K' kein Elektronenstrom mehr in die darunterliegende Thyristorstruktur fließt, liegt auch die p-Basis 3 in dem mittleren Bereich auf dem gleichen Potential wie die n-Emitterzone 4. In den seitlichen Bereichen ist es etwas niedriger, z. B. 7 V, da zum Abbau der Ladungsträger in der p-Basis 3 und der n-Basiszone 2 und zum Aufbau der Raumladungszone (RLZ) Löcher dorthin und durch den Kanal zur Kathode K fließen. Als Vorbedingung für die beschriebene Funktionsweise wird die Durchbruchspannung V_{Br}(M1) des extern ansteuerbaren MOSFETs M1, die durch den pn-Übergang J₄ bestimmt wird, größer eingestellt als die Schwellenspannung V_{T}(M2) des MOSFETs M2.

Indem man den Kanal des MOSFETs M1 durch Kurzschließen des Gates mit dem Source zum Verschwinden bringt, wird also zum einen der Elektronenstrom aus der floatenden Kathode K' in den Thyristor unterbrochen, zum anderen aber bildet sich automatisch ein p-Kanal im MOSFET M2 und damit ein Strompfad für die Löcher zur Kathode.

Damit ein gut leitender p-Kanal im MOSFET M2 entsteht, sollte die Durchbruchspannung V_{Br}(M1) des MOSFETs M1 die Schwellenspannung V_{T} (M2) von M2 um mindestens 2 V übersteigen. Zweckmäßig ist eine Differenz von 10 V. Die Schwellenspannung V_{T}(M2) von M2 wird klein gewählt, vorzugsweise in dem Bereich 1 V bis 5 V, damit der MOSFET M2 beim Abschalten von M1 schnell einschaltet. Kleiner als 1 V darf die Schwellenspannung V_{T}(M2) nicht sein, da sonst schon im ON-Zustand des Bauelements ein Nebenweg zwischen p-Basis und Kathode vorhanden ist.

Um eine kleine Schwellenspannung zu bekommen, ist es günstig, als Gatematerial Bor-dotiertes Polysilizium zu verwenden, das bei dem MOSFET M2 daher vorteilhafterweise das unmittelbar dem Oxid aufliegende Gate bildet, das bei der Ausführungsform gemäß Fig. 1 noch von der Kathodenmetallisierung bedeckt ist.

Die Kennlinie des Bauelements im On-Zustand, also bei negativer Spannung des Gates gegenüber der floatenden Kathode K', geht mit steigender Spannung in einen Bereich nahezu konstanten Stroms über, der zum Unterschied von der des MOSFETs M1 bis zu sehr hohen Spannungen reicht. Ähnlich wie in Fig. 2 für das Abschalten dargestellt, bildet sich dabei ein p-Kanal in dem internen MOSFET M2, sobald die Spannung am MOSFET M1 die Schwellenspannung des MOSFETs M2 übersteigt. Von diesem Punkt ab fällt der effektive Stromverstärkungsfaktor α_{npn,eff} des npn-Teiltransistors (4a,3,2) infolge des Nebenweges mit weiterer Erhöhung des Stroms stark ab, so daß der Thyristor aus der Sättigung geht und der mittlere pn-Übergang J₂ Spannung aufnimmt. Die Kennlinie wird dann durch den pnp-Transistor (bestehend aus p-Emitterzone 1, n-Basiszone 2 und p-Basis 3) bestimmt, der mit konstantem Basistrom aus dem MOSFET M1 aufgesteuert wird und dessen Kollektorstrom im aktiven Bereich nicht stark mit der Spannung ansteigt. Der Teil dieses Kollektorstroms, der nicht zur Aufsteuerung des npn-Teiltransistors (bestehend aus n-Emitterzone 4, p-Basis 3 und n-Basiszone 2) benötigt wird, fließt durch den p-Kanal des internen MOSFETs M2 zur Kathode und ergibt zusammen mit dem Strom des MOSFETs M1 den Strom des Gesamtbauelements. Dieser steigt daher nicht mehr stark mit der Spannung an. Im Kurzschlußfall läuft der Arbeitspunkt in diesen Kennlinienbereich annähernd konstanten Stroms, von dem aus man das Bauelement dann abschaltet, indem man die Gatespannung kleiner als die Schwellenspannung macht.

Das Bauelement nach Fig. 1 und 2 kann als Integration einer sogenannten Kaskodenschaltung angesehen werden, die ein schnelles Abschalten z. B. eines Hochleistungs-GTOs mit geringer Steuerleistung ermöglicht, indem ein in Serie liegender Niederspannungs-MOSFET abgeschaltet wird und die sich daran aufbauende Spannung als Gatespannung den GTO abschaltet. Die diskrete Kaskodenschaltung wird jedoch nicht häufig eingesetzt, da sie wegen der zusätzlich zum GTO benötigten Bauelemente im allgemeinen kostenungünstig ist und viel Raum in Anspruch nimmt. Die monolithische Integration nach der Erfindung ist in dieser Hinsicht wesentlich günstiger. Geringe Störanfälligkeit und Abwesenheit von Streuinduktivitäten sind weitere Vorteile.

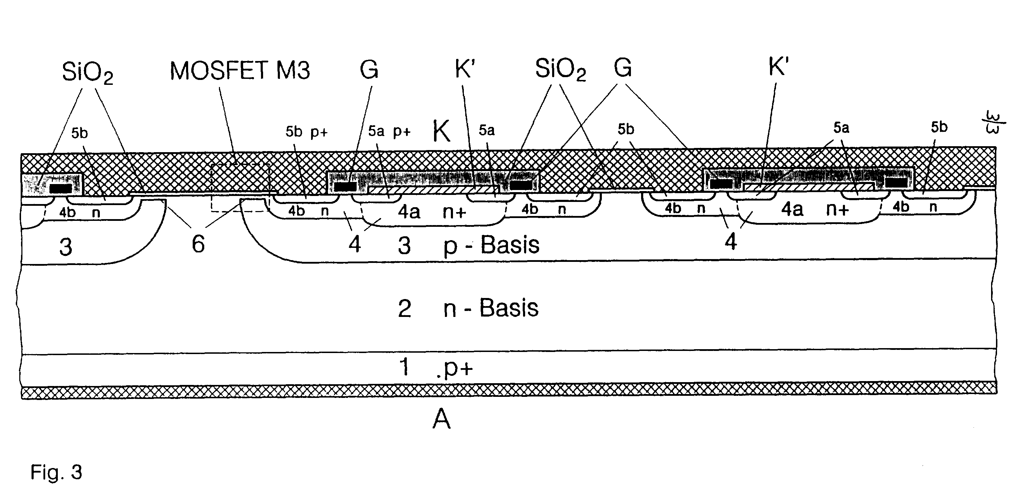

Zum Einschalten des Leistungshalbleiterbauelements aus dem (Vorwärts-)Sperrzustand in den Durchlaßzustand reicht es im allgemeinen nicht aus, den in Serie liegenden MOSFET M1 einzuschalten, da der Thyristor weiterhin sperrt. Nur bei einer in Vorwärtsrichtung an sich nicht sperrenden Thyristorstruktur würde man das Bauelement in der in Fig. 1 und 2 gezeigten Form so einschalten können. Eine solche Thyristorstruktur ist aber bei schnellen Bauelementen nur schwer erreichbar und liegt insbesondere dann nicht vor, wenn der anodenseitige Emitterbasisübergangs J₁ zur Verbesserung der dynamischen Eigenschaften geshortet ist. Daher muß die Struktur noch mit einem Mechanismus zum Zünden des Thyristors versehen werden. Eine Anordnung mit einer Einheitszelle, bei das Zünden ohne zusätzliches Gate durch die Struktur des Halbleiters erreicht wird, sobald der MOSFET M1 eingeschaltet wird, ist in Fig. 3 dargestellt. Die Einheitszelle mit Zündvorrichtung (Zündeinheitszelle) befindet sich in der Figur zusammen mit einem Teil einer benachbarten Zündeinheitszelle auf der linken Seite, nach rechts schließt sich eine normale Zelle an, mit der nur abgeschaltet werden kann. Die Kathodenmetallisierung erstreckt sich auch über das Gate und die floatende Kathode, die durch eine Zwischenschicht, die in der Regel aus Siliziumdioxid besteht, isoliert sind.

Die Zündeinheitszelle ist dadurch gekennzeichnet, daß an ihrem Rande die n-Basis 2 bis an die Oberfläche geführt ist und die p-Basis 3 an der Oberfläche endet, wie Fig. 3 zeigt. In den Oberflächenbereich der p-Basis ist jedoch ein n-Kanal 6 eindotiert, der die n-Emitterzone 4 mit der n-Basis 2 verbindet und zusammen mit einem isolierten Gate einen n-Kanal-MOSFET M3 vom Verarmungstyp bildet. Das Gate liegt auf Kathodenpotential und wird in der gezeigten Ausführungsform gleichzeitig durch die Kathodenmetallisierung dargestellt, die das Gateoxid mit überdeckt. Wird nun durch eine negative Spannung am äußeren Gate G ein p-Kanal zwischen den Gebieten 5a und 5b erzeugt, der die Kathode K über die floatende Kathode K' mit der Thyristorstruktur verbindet, so fließt über den n-Kanal 6 des internen MOSFETs M3 ein Elektronenstrom in die n-Basiszone und zündet den Thyristor der Zündeinheitszelle. Der eingeschaltete Zustand breitet sich dann durch laterale Ströme in der p- und n-Basis in bekannter Weise auf die nächsten Einheitszellen aus, so daß nur ein kleiner Prozentsatz der Zellen eine Zündstruktur besitzen muß.

Das Sperrvermögen und Abschaltverhalten wird durch die Zündeinheitszelle nicht beeinträchtigt. Wird nämlich der p-Kanal des externen MOSFETs M1 durch Kurzschließen des Gates G mit K' zum Verschwinden gebracht, so steigt das Potential der p-Basis auf positive Werte gegenüber der Kathode K, wie bei der Erläuterung des Abschaltens anhand von Fig. 2 beschrieben. Sobald die Potentialdifferenz gegenüber K die Schwellenspannung V_{T}(M3) des MOSFETs M3 übersteigt, verschwindet der n-Kanal des MOSFETs M3, da dessen Gate K gegenüber dem Halbleiter negativ gepolt ist. Damit ist die Verbindung zwischen n-Basis 2 und n-Emitterzone 4 unterbrochen, und der pn-Übergang J₂ zwischen n- und p-Basis wird voll sperrfähig. Damit die Schwellenspannung V_{T}(M3) - absolut genommen - überschritten werden kann, muß sie wie beim MOSFET M2 kleiner als die Durchbruchspannung V_{Br}(M1) des MOSFETs M1 sein.

Die Bedingung einer kleinen Schwellenspannung und einer deutlich höheren Durchbruchspannung der MOSFETs kann durch die Dotierung des Bereichs 4b der n-Emitterzone 4 und durch den Dotierungsgradienten am pn-Übergang J₄ auf verschiedener Weise technologisch realisiert werden. Um den Einfluß des aus den Zonen 5b, 4b und 3 gebildeten parasitären Transistors zu unterdrücken und um einen Punch-Through zu vermeiden, darf die Dotierung der Zone 4b andererseits nicht zu niedrig sein. Für die integrale Dotierung hat sich der Bereich 5*10¹³/cm² bis 5*10¹⁴/cm² als zweckmäßig erwiesen.

In den bisherigen Ausführungsbeispielen war der extern ansteuerbare Feldeffekttransistor M1 ein MOSFET vom Anreicherungstyp, bei dem der Kanal durch Inversion des Substrats, der n-Emitterzone 4, erzeugt wird. Der MOSFET M1 kann aber auch ein solcher vom Verarmungstyp sein, bei dem der p-Kanal zwischen den Gebieten 5a und 5b infolge einer p-Dotierung, also schon ohne Gatespannung, vorhanden ist und durch positive Gatespannung zum Verschwinden gebracht werden kann. Die anderen Ausgestaltungen der Erfindung bleiben unverändert. Ohne Spannung am Gate befindet sich dieses Bauelement im eingeschalteten Zustand, durch positive Spannung zwischen G und K' wird es abgeschaltet.

In den Ausführungsbeispielen wurde eine konkrete Aufeinanderfolge der p- und n-Zonen angenommen, so wie sie praktisch i. a. bevorzugt wird. Jedoch ergeben sich durch Vertauschung des p- und n-Leitungstyp ebenfalls funktionsfähige Bauelemente im Rahmen der Erfindung, die als inverse Bauelemente für bestimmte Anwendungen erwünscht sind.

Die inverse Struktur hat den Vorteil, daß der in Serie mit dem Thyristor liegende MOSFET M1 und auch der MOSFET M2 nun n-Kanal-MOSFETs sind, die einen wesentlichen geringeren Kanalwiderstand haben als p-Kanal-MOSFETs. Andererseits werden die Schalteigenschaften des Thyristor nun dadurch verschlechtert, daß er von der Anodenseite her abgeschaltet wird, was bei vergleichbarem sicheren Arbeitsbereich eine dickere schwach dotierte Basis erfordert.

## Patentansprüche

1. Durch MOS-Gate schaltbares Leistungshalbleiterbauelement mit einem Halbleiterkörper, der eine Vielzahl nebeneinander angeordneter, parallel geschalteter, eine Thyristorstruktur bildende Einheitszellen aufweist, die aus einer an die Anode angrenzenden p-Emitterzone (1), einer sich daran anschließenden schwach dotierten n-3asiszone (2), einer darauf folgenden p-Basiszone (3) und einer sich daran anschließenden n-Emitter-zone (4) bestenen, in die paarweise p+-Zonen eingebettet sind, die zusammen mit dem zwischen ihnen liegenden n-Gebiet und einem darüber angeordneten isolierten Gate (G) einen lateralen ersten p-Kanal-MOSFET (M1) bilden, wobei einerseits das am Rande der Emitterzone liegende Draingebiet mit der äußeren Kathode (K) verbunden ist, die nur einen indirekten Kontakt mit der n-Emitterzone hat, und andererseits das innen liegende Sourcegebiet mit einem floatenden Kontakt (K') versehen ist, der gleichzeitig die n-Emitterzone (4) kontaktiert, und wobei aus der mit der äußeren Kathode (K) kontaktzeiten p+-Zone (5b), dem Oberflächenbereich der p-Basiszone (3) und dem dazwischen liegenden Bereich der n-Emitterzone (4b) zusammen mit einem isolierten Gate ein zweiter p-Kanal-MOSFET (M2) gebildet wird,
**dadurch gekennzeichnet,**
daß die Durchbruchsspannung des ersten lateralen p-Kanal-MOSFETs (M1) zwischen der äußeren Kathode (K) und dem floatenden Kontakt (K') den Absolutbetrag der Schwellenspannung des zweiten MOSFETS (M2) um mehr als zwei Volt übersteigt und daß die Gateelektrode des zweiten MOSFETS (M2) von der Kathodenmetallisierung mitgebildet oder überdeckt wird, so daß ein elektrischer Kontakt zwischen den beiden vorhanden ist.

2. Leistungshalbleiterbauelement nach Anspruch 1, wobei in einem Teil der Einheitszellen ein Oberflächenbereich der n-Basiszone (2), die n-Emitterzone (4b) und der dazwischenliegende Oberflächenbereich der p-Basiszone (3) zusammen mit einem isolierten Gebiet einen n-Kanal-MOSFET (M3) bilden,
dadurch gekennzeichnet, daß der n-Kanal-MOSFET (M3) vom Verarmungstyp ist und daß der Absolutbetrag der Schwellenspannung des n-Kanal-MOSFETs (M3) vom Verarmungstyp wenigstens um zwei Volt kleiner als die Durchbruchs spannung des ersten p-Kanal-MOSFETs ist und daß die Gateelektrode des n-Kanal-MOSFETs (M3) von der Kathodenmetallisierung mitgebildet oder überdeckt wird, so daß ein elektrischer Kontakt zwischen den beiden vorhanden ist.

3. Leistungshalbleiterbauelement nach Anspruch 1 oder 2,
dadurch gekennzeichnet, daß die Schwellenspannungen des zweiten MOSFETs (M2) und des n-Kanal-MOSFETs (M3) im Bereich von 1 V bis 5 V liegen.

4. Leistungshalbleiterbauelement nach einem oder mehreren der vorhergehenden Ansprüche,
dadurch gekennzeichnet, daß die n-Emitterzone (4) im Bereich (4a) unter dem floatenden Kathodenkontakt (K') höher dotiert ist als im übrigen Bereich (4b), der die Durchbruchsspannungen und Schwellenspannungen der MOSFETs (M1, M2, M3) bestimmt.

5. Leistungshalbleiterbauelement nach Anspruch 4,
dadurch gekennzeichnet, daß die integrale Dotierung im übrigen Bereich (4b) der n-Emitterzone (4) im Bereich 5 x 10¹³/cm² bis 5 x 10¹⁴/cm² liegt.

6. Inverses Leistungshalbleiterbauelement entsprechend einem oder mehreren der vorhergehenden Ansprüche,
dadurch gekennzeichnet, daß der Dotierungstyp der Zonen (1, 2, 3, 4, 5) und Gebiete jeweils durch den komplementären Dotierungstyp ersetzt ist.

## Claims

1. Power semiconductor element, which is switchable by a MOS gate, with a semiconductor body having a plurality of parallelly connected unit cells which are arranged adjacent to one another and form a thyristor and which consist of a p-emitter zone (1) adjacent to the anode, a weakly doped n-base zone (2) adjoining thereat, a p-base zone (3) following thereon and an n-emitter zone (4) adjoining thereat, in which p+ zones are embedded in pairs, which together with the n-region disposed therebetween and an insulating gate (G) arranged thereabove form a lateral first p-channel MOSFET (M1), wherein at one side the drain region lying at the edge of the emitter zone is connected with the outer cathode (K), which has only an indirect contact with the n-emitter zone, and at the other side the inwardly disposed source zone is provided with a floating contact (K'), which at the same time contacts the n-emitter zone (4), and wherein a second p-channel MOSFET (M2) is formed from the p+ zone (5b) contacted by the outer cathode (K), the surface region of the p-base zone (3) and the region disposed therebetween of the n-emitter zone (4b) together with an insulating gate, characterised thereby that the breakdown voltage of the first lateral p-channel MOSFET (M1) between the outer cathode (K) and the floating contact (K') exceeds the absolute amount of the threshold voltage of the second MOSFET (M2) by more than two volts and that the gate electrode of the second MOSFET (M2) is co-formed or covered by the cathode metallisation, so that an electrical contact is present between the two.

2. Power semiconductor element according to claim 1, wherein in one part of the individual cells a surface region of the n-base zone (2), the n-emitter zone (4b) and the intermediately disposed surface region of the p-base zone (3) together with an insulating region form an n-channel MOSFET (M3), characterised thereby that the n-channel MOSFET (M3) is of the weakening type and that the absolute amount of the threshold voltage of the n-channel MOSFET (M3) of the weakening type is smaller by at least two volts than the breakdown voltage of the first p-channel MOSFET and that the gate electrode of the n-channel MOSFET (M3) is co-formed or covered by the cathode metallisation, so that an electrical contact is present between the two.

3. Power semiconductor element according to claim 1 or 2, characterised thereby that the threshold voltages of the second MOSFET (M2) and the n-channel MOSFET (M3) lie in the region of 1 volt to 5 volts.

4. Power semiconductor element according to one or more of the preceding claims, characterised thereby that the n-emitter zone (4) is doped higher in the region (4a) below the floating cathode contact (K') than in the remaining region (4b) which determines the breakdown voltages and threshold voltages of the MOSFETs (M1, M2, M3).

5. Power semiconductor element according to claim 4, characterised thereby that the integral doping in the remaining region (4b) of the n-emitter zone (4) lies in the range of 5 x 10¹³/cm² to 5 x 10¹⁴/cm².

6. Inverse power semiconductor element corresponding to one or more of the preceding claims, characterised thereby that the doping type of the zones (1, 2, 3, 4, 5) and regions is replaced each time by the complementary doping type.

## Revendications

1. Composant semi-conducteur de puissance commutable par porte MOS, avec un corps semi-conducteur qui présente une pluralité de cellules unitaires disposées les unes à côté des autres, montées en parallèle, formant une structure de thyristor, qui sont constituées d'une zone émettrice p (1) avoisinant l'anode, d'une zone de base n (2) faiblement dotée faisant suite à celle-ci, d'une zone de base p (3) faisant suite à celle-ci et d'une zone émettrice n (4) faisant suite à celle-ci dans lesquelles sont noyées, par paires, des zones p+ qui forment conjointement avec la zone n située entre celle-ci et une porte isolée (G) disposée au-dessus un premier MOSFET latéral à canal p (M1) où, d'une part, la zone de drain située au bord de la zone émettrice est reliée à la cathode externe (K) qui a seulement un contact indirect avec la zone émettrice n et, d'autre part, la zone de source située à l'intérieur est pourvue d'un contact flottant (K) qui contacte en même temps la zone émettrice n (4) et où il est formé par la zone p+ (5b) en contact avec la cathode externe (K), la zone de surface de la zone de base p (3) et la zone située entre de la zone émettrice n (4b) conjointement avec une porte isolée, un deuxième MOSFET à canal p (M2), caractérisé en ce que la tension de claquage du premier MOSFET latéral à canal p (M1) entre la cathode externe (K) et le contact flottant (K') dépasse la valeur absolue de la tension seuil du deuxième MOSFET (M2) de plus de deux volts et que l'électrode de porte du deuxième MOSFET (M2) est formée aussi par la métallisation de cathode ou est recouverte de façon qu'il existe un contact électrique entre les deux.

2. Composant semi-conducteur de puissance selon la revendication 1, où dans une partie des cellules unitaires, une zone de surface de la zone de base n (2), la zone émettrice n (4b) et la zone de surface située entre de la zone de base p (3) forment ensemble avec une zone isolée un MOSFET à canal n (M3), caractérisé en ce que le MOSFET à canal n (M3) est du type à déplétion et que la valeur absolue de la tension seuil du MOSFET à canal n (M3) du type à déplétion est au moins de deux volts inférieurs à la tension de claquage du premier MOSFET canal p, et en ce que l'électrode de porte du MOSFET canal n (M3) est formée aussi ou recouverte par la métallisation de cathode de façon qu'il existe un contact électrique entre les deux.

3. Composant semi-conducteur de puissance selon la revendication 1 ou 2, caractérisé en ce que les tensions seuils du deuxième MOSFET (M2) et du MOSFET à canal n (M3) se situent dans la zone de 1V à 5V.

4. Composant semi-conducteur de puissance selon l'une ou plusieurs des revendications précédentes, caractérisé en ce que la zone émettrice n (4) dans la région (4a) sous le contact de cathode flottant (K') est doté plus fortement que dans la région restante (4b) qui détermine les tensions de claquage et les tensions seuils des MOSFETs (M1, M2, M3).

5. Composant semi-conducteur de puissance selon la revendication 4, caractérisé en ce que le dopage intégral dans la zone restante (4b) de la zone émettrice n (4) se situe dans la zone de 5 x 10¹³/cm² jusqu'à 5 x 10¹⁴/cm².

6. Composant semi-conducteur de puissance inverse selon l'une ou plusieurs des revendications précédentes, caractérisé en ce que le type de dopage des zones (1, 2, 3, 4, 5) et des régions est remplacé respectivement par le type de dopage complémentaire.
